(19) Europäisches Patentamt / European Patent Office / Office européen des brevets

(11) **EP 4 718 084 A1**

(12) **EUROPEAN PATENT APPLICATION**

(43) Date of publication:
**01.04.2026  Bulletin 2026/14**

(21) Application number: 25202987.1

(22) Date of filing: **18.09.2025**

(51) International Patent Classification (IPC):
*G01R 19/165* (2006.01)     *G05F 1/46* (2006.01)
*G05F 1/56* (2006.01)       *G05F 1/565* (2006.01)
*G05F 1/569* (2006.01)      *G05F 1/573* (2006.01)
*G05F 1/59* (2006.01)       *G05F 1/613* (2006.01)
*G06F 1/30* (2006.01)       *H03F 3/45* (2006.01)
*G08C 19/02* (2006.01)      *H04B 3/00* (2006.01)
*G05F 1/618* (2006.01)

(52) Cooperative Patent Classification (CPC):
G08C 19/02; G01R 19/165; G05F 1/462;
G05F 1/56; G05F 1/565; G05F 1/569; G05F 1/573;
G05F 1/5735; G05F 1/59; G05F 1/613; G05F 1/618

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority:  **25.09.2024  JP 2024166456**

(71) Applicant: **Yokogawa Electric Corporation
Tokyo 180-8750 (JP)**

(72) Inventor: **IWANO, Youichi
Musashino-shi, Tokyo, 180-8750, (JP)**

(74) Representative: **Winter, Brandl - Partnerschaft
mbB
Alois-Steinecker-Straße 22
85354 Freising (DE)**

(54) **CONSTANT CURRENT DEVICE AND FAILURE DETECTION METHOD**

(57)     An error amplifier (Q2) generates an electric current signal that is constant electric current. A signal processing circuit (102) inputs input voltage for generating an electric current signal having a target electric current value, to the error amplifier (Q2), and detects a failure by comparing a voltage value of voltage output from the error amplifier (Q2) with a determination voltage value.

**EP 4 718 084 A1**

**Description**

CROSS-REFERENCE TO RELATED APPLICATIONS

The present application claims priority to and incorporates by reference the entire contents of Japanese Patent Application No. 2024-166456 filed in Japan on September 25, 2024.

FIELD

The present invention relates to constant current devices and failure detection methods.

BACKGROUND

A two-wire transmitter is a device that is connected to an external circuit via two transmission lines, converts a physical quantity acquired from a sensor, for example, into an electric current signal, and outputs the electric current signal to the external circuit, while the external circuit serves as a power source. Two-line transmitters are widely used as field devices, such as differential pressure/pressure transmitters and temperature transmitters in various plants using petroleum, petrochemistry, chemistry, and gases, for example, because two-line transmitters do not require dedicated power source wiring and are able to be installed inexpensively. A two-line transmitter utilized as a field device converts a physical quantity into direct electric current of 4 mA to 20 mA as a signal from the field device and transmits the signal to an external circuit.

A two-line transmitter is connected to an external circuit via two transmission lines and operates, with the external circuit serving as a power source. Furthermore, the two-line transmitter has: an error amplifier, such as an operational amplifier, which compares a voltage based on a physical quantity acquired from a sensor with a reference voltage and operates so as to cause them to agree with each other; and a constant current circuit including a transistor where electric current flowing therethrough is controlled by output from the error amplifier. The two-line transmitter then outputs a specific electric current signal of 4 mA to 20 mA representing the physical quantity acquired from the sensor, to the external circuit (for example, Japanese Laid-open Patent Publication No. 2012-99088). The external circuit supplies power source voltage to the two-line transmission line and acquires a physical quantity measured by the two-line transmitter by reading a voltage corresponding to the specific electric current signal transmitted from the two-line transmission line.

However, due to a failure in its circuitry or a shortage of the power source voltage in the two-line transmitter, the specific electric current signal transmitted may abnormally differ from a set electric current. For example, in a case where a failure occurs in the transistor that supplies electric current for generating the specific electric signal representing the physical quantity, an electric current different from the set electric current based on control by the operational amplifier flows to the transistor and the electric current signal representing the physical quantity will not represent an accurate value as a result. In this case, it is difficult for the conventional two-line transmitter to detect the abnormal difference between the electric current signal transmitted and the set electric current and thus to communicate the failure to the external circuit. Therefore, there is a risk that the conventional two-line transmitter including the constant current circuit may continue to operate with the failure and decrease in reliability.

In one aspect of the present invention, detecting an abnormal difference between an electric current value of an electric current signal that actually flows and a set electric current value enables improvement in reliability of a constant current device.

SUMMARY

It is an object of the present invention to at least partially solve the problems in the conventional technology.

According to an aspect of an embodiment, a constant current device includes an error amplifier that generates an electric current signal that is constant electric current, and a signal processing circuit that inputs input voltage for generating the electric current signal having a target electric current value to the error amplifier and detects a failure by comparing a voltage value of voltage output from the error amplifier with a determination voltage value.

The above and other objects, features, advantages and technical and industrial significance of this invention will be better understood by reading the following detailed description of presently preferred embodiments of the invention, when considered in connection with the accompanying drawings.

BRIEF DESCRIPTION OF THE DRAWINGS

FIG. 1 is a circuit diagram of a two-line transmitter according to a first embodiment;

FIG. 2 is a flowchart of a failure detection process by the two-line transmitter, according to the first embodiment;

FIG. 3 is a circuit diagram of a two-line transmitter according to a second embodiment;

FIG. 4 is a circuit diagram of a two-line transmitter according to a third embodiment;

FIG. 5 is a circuit diagram of a two-line transmitter according to a fourth embodiment; and

FIG. 6 is a circuit diagram of a two-line transmitter according to a fifth embodiment.

DESCRIPTION OF EMBODIMENTS

Embodiments of a constant current device and a failure detection method will be described hereinafter, while reference is made to the drawings. The same reference sign will be assigned to any components that are the same and any redundant description thereof will be omitted as appropriate. The embodiments may be combined as appropriate so long as no contradictions arise from the combination.

First Embodiment

Overall Configuration

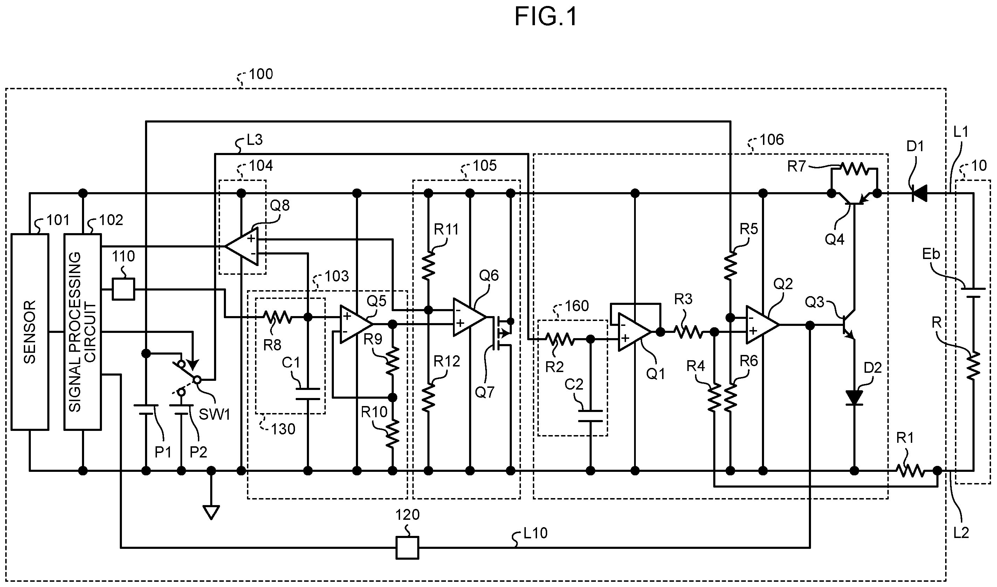

FIG. 1 is a circuit diagram of a two-line transmitter according to a first embodiment. As illustrated in FIG. 1, a two-line transmitter 100 is connected to an external circuit 10 via transmission lines L1 and L2. The two-line transmitter 100 operates, with the external circuit 10 serving as a power source.

The external circuit 10 has a power source voltage Eb and a detection resistance R that have been connected in series with the transmission lines L1 and L2. The external circuit 10 supplies electric power to the two-line transmitter 100, with the power source voltage Eb serving as the power source. Furthermore, the external circuit 10 acquires a physical quantity measured by the two-line transmitter 100 by reading a voltage across the detection resistance R.

The two-line transmitter 100 is a field device, such as a differential pressure/pressure transmitter or a temperature transmitter, and outputs a specific electric current signal representing a physical quantity to the external circuit 10. The two-line transmitter 100 has a sensor 101, a signal processing circuit 102, a reference voltage processing circuit 103, a comparator circuit 104, a shunt regulator circuit 105, a constant current circuit 106, a diode D1, a feedback resistance R1, and an analog-digital (AD) conversion circuit 120.

Configuration of Each Component

The sensor 101 measures a physical quantity, such as a pressure or a temperature, in a plant. The sensor 101 converts the physical quantity measured, into an electric signal, and outputs the electric signal to the signal processing circuit 102.

The signal processing circuit 102 receives input of the electric signal representing the physical quantity, from the sensor 101. The signal processing circuit 102 then subjects the electric signal acquired to predetermined processing, for example, linearity correction (distortion correction) or noise removal. Subsequently, the signal processing circuit 102 converts the electric signal that has been subjected to the predetermined processing, to an electric current signal pulse width modulation (PWM) signal. The signal processing circuit 102 then outputs the electric current signal PWM signal generated, as a switch control signal, to a switch SW1. Electric current targeted by control based on the electric current signal PWM signal generated by the signal processing circuit 102 will herein be referred to as "control electric current".

The signal processing circuit 102 holds an upper limit sticking determination value and a lower limit sticking determination value, for the control electric current. The upper limit sticking determination value is a threshold for determining that voltage is stuck to a circuit voltage, which is an upper limit value. An upper limit determination threshold is set to, for example, 2.95 V in a case where the circuit voltage is 3 V. The lower limit sticking determination value is a threshold for determining that voltage is stuck to a circuit common voltage, which is a lower limit value. A lower limit determination threshold is set to, for example, 0.05 V in a case where the circuit common voltage is 0 V. In a case where a voltage is between the upper limit sticking determination value and the lower limit sticking determination value, the signal processing circuit 102 determines that operation is normal. These upper limit sticking determination value and lower limit sticking determination value are each an example of a "determination voltage value".

The signal processing circuit 102 receives input of an abnormality notification signal from the AD conversion circuit 120, the abnormality notification signal resulting from conversion of output voltage from an error amplifier Q2 into a digital signal. The signal processing circuit 102 then compares a voltage value represented by the abnormality notification signal with the upper limit sticking determination value and the lower limit sticking determination value.

In a case where the voltage value represented by the abnormality notification signal is larger than the upper limit sticking determination value, the signal processing circuit 102 determines that the voltage is stuck to the circuit voltage, which is the upper limit value. The signal processing circuit 102 then performs control so that an electric current value of the electric current signal becomes a value outside and smaller than a normal range by changing the electric current signal PWM signal. For example, in a case where the normal range is 4 mA to 20 mA, the signal processing circuit 102 executes control so that the electric current value of the electric current signal becomes 3 mA. The signal processing circuit 102 thereby notifies the external circuit 10 of an abnormality.

Furthermore, in a case where the voltage value represented by the abnormality notification signal is smaller than the lower limit sticking determination value, the signal processing circuit 102 determines that the voltage is stuck to the circuit common voltage, which is the lower limit value. The signal processing circuit 102 then performs control so that the electric current value of the electric current signal becomes a value outside and larger than the normal range by changing the electric current signal PWM signal. For example, in the case where the normal range is 4 mA to 20 mA, the signal processing circuit 102 performs control so that the electric current value of the electric current signal becomes 23 mA. The signal processing circuit 102 thereby notifies the external circuit 10 of an abnormality.

However, the signal processing circuit 102 does not necessarily use the electric current signal PWM signal as the switch control signal. For example, in a case where the signal processing circuit 102 is capable of outputting analog voltage, an output of the signal processing circuit 102 may be directly connected to a line L3.

As described above, the signal processing circuit 102 inputs input voltage for causing the electric current signal to be generated, to the error amplifier Q2, the electric current signal having the target electric current value, and detects a failure by comparing the voltage value of the voltage output from the error amplifier Q2 with the upper limit sticking determination value and lower limit sticking determination value, which are determination voltage values. In particular, the signal processing circuit 102 according to the embodiment detects occurrence of the failure on the basis of the digital signal input from the AD conversion circuit 120. Furthermore, in a case where a failure has been detected, the signal processing circuit 102 makes a notification of occurrence of the failure by controlling the input voltage to the error amplifier Q2 so that the electric current value of the electric current signal becomes a value outside a predetermined normal range, that is, outside the range of 4 mA to 20 mA in this embodiment.

In addition, a reference voltage output unit 110 is connected to the signal processing circuit 102. The signal processing circuit 102 outputs the specific electric signal corresponding to the electric signal from the sensor 101, to the reference voltage output unit 110. For example, the signal processing circuit 102 outputs, as the specific electric signal, a signal resulting from mere amplification of the electric signal, to the reference voltage output unit 110.

In addition, the signal processing circuit 102 is connected to the comparator circuit 104. Upon receipt of a notification of occurrence of an abnormality from the comparator circuit 104, the signal processing circuit 102 executes processing, such as storage of a present value of the electric signal input from the sensor 101.

A positive electrode of a reference voltage source P1 having first output voltage is connected to one of fixed contacts of the switch SW1. A positive electrode of a reference voltage source P2 having second output voltage is connected to the other one of the fixed contacts of the switch SW1. One end of the line L3 is connected to a movable contact of the switch SW1. It is assumed herein that the first output voltage has a voltage level of VR1 (V) and the second output voltage has a voltage level of VR2 (V).

The movable contact of the switch SW1 switches between the reference voltage source P1 with the voltage level of VR1 and the reference voltage source P2 with the voltage level of VR2, according to changes in voltage level of the electric current signal PWM signal. Switching of the movable contact of the switch SW1 results in flow of an electric signal that changes in voltage level between VR1 and VR2, through the line L3 connected to the movable contact of the switch SW1.

The other end of the line L3 is connected to the constant current circuit 106. The constant current circuit 106 determines a value of the electric signal flowing through the line L3, that is, a value of the electric current signal to be output to the external circuit 10 according to the electric signal output from the sensor 101. The constant current circuit 106 has a low pass filter (LPF) 160, a buffer amplifier Q1, resistances R3 to R6, the error amplifier Q2, transistors Q3 and Q4, a resistance R7, and a diode D2. The diode D2 may be replaced by a resistance. The following description is on details of operation of the constant current circuit 106.

The LPF 160 including a resistance R2 and a capacitor C2 receives input of the electric signal flowing through the line L3. The LPF 160 smoothes the electric signal input, into an analog signal. Thereafter, the LPF 160 outputs the electric signal that has been converted into the analog signal, to the buffer amplifier Q1.

An output terminal of the buffer amplifier Q1 is connected to the resistance R3 connected to the error amplifier Q2. The buffer amplifier Q1 receives input of the electric signal that has been converted into the analog signal, from the LPF 160. The buffer amplifier Q1 then buffers the electric signal input and outputs the electric signal buffered, from the output terminal, to the error amplifier Q2 via the resistance R3.

The buffer amplifier Q1, the resistance R2, and the capacitor C2 may be not installed in the two-line transmitter 100 in a case where the signal processing circuit 102 has a configuration other than a configuration that outputs a PWM signal, for example, a configuration that outputs DC voltage using a DA converter.

The error amplifier Q2 is, for example, an operational amplifier. However, a form other than an operational amplifier may be used as the error amplifier Q2. A voltage that is a difference between the output voltage from the buffer amplifier Q1 and a feedback voltage generated across the feedback resistance R1 is divided by the resistances R3 and R4, and the feedback resistance R1, and then input to a noninverting input terminal of the error amplifier Q2. These resistances R3 and R4 correspond to an example of "a first resistance and a second resistance". A voltage of VR1 (V) from the reference voltage source P1 is divided by the resistances R5 and R6 and then input to an inverting input terminal of the error amplifier Q2.

An output terminal of the error amplifier Q2 is connected to a base of the transistor Q3. The error amplifier Q2 controls collector electric current of the transistor Q3 by inputting voltage output to the base of the transistor Q3. More specifically, the error amplifier Q2 detects any error between the voltages respectively input to the noninverting input terminal and inverting input terminal, and controls, together with the transistors Q3 and Q4, electric current flowing in circuitry by adjusting the voltage output so that the voltages agree with each other.

That is, the error amplifier Q2 detects the error between the voltage resulting from the division of the voltage output by the error amplifier Q2 by the feedback resistance R1 and the resistances R3 and R4, and the voltage resulting from the division of the output voltage from the reference voltage source P1 by the resistances R5 and R6. The error amplifier Q2 then controls the electric current flowing to the transistors Q3 and Q4 so that the voltages input agree with each other. That is, the resistances R3 and R4, which are the first resistance and the second resistance, play a role of adjusting the input voltages on the basis of voltage based on a potential difference across the feedback resistance R1, so that the electric current value of the electric current signal becomes close to the target electric current value.

In a case where a failure occurs in the resistance R7 or the transistor Q4, any difference generated between the electric current signal actually flowing through the transmission line L1 and the control electric current set by the signal processing circuit 102 generates a potential difference between the voltage at the negative terminal and the voltage at the positive terminal of the error amplifier Q2. In a case where a potential difference is generated, the error amplifier Q2 has a large gain, and the voltage value of the voltage output by the error amplifier Q2 thus becomes a value that is: stuck to the circuit voltage, which is the upper limit; stuck to the circuit common voltage, which is the lower limit; or around the circuit voltage or the circuit common voltage. More specifically, in a case where the electric current value of the electric current signal actually flowing through the transmission line L1 is larger than the electric current value of the control electric current, the voltage output by the error amplifier Q2 has a value that is stuck to the circuit common voltage or that is around the circuit common voltage. On the contrary, in a case where the electric current value of the electric current signal actually flowing through the transmission line L1 is smaller than the electric current value of the control electric current, the voltage output by the error amplifier Q2 has a value that is stuck to the circuit voltage or that is around the circuit voltage.

The transistor Q3 is an NPN transistor. A collector of the transistor Q3 is connected to a base of the transistor Q4. An emitter of the transistor Q3 is connected to the diode D2. Adjustment of the voltage input to the base of the transistor Q3 by the error amplifier Q2 changes the electric current passed by the transistor Q3 and the base electric current of the transistor Q4 is thereby controlled. This transistor Q3 corresponds to an example of a "second transistor".

The transistor Q4 is a PNP transistor. An emitter and a collector of the transistor Q4 are connected to the transmission line L1. The emitter of the transistor Q4 is connected to an output terminal of the diode D1 where electric current output from the external circuit 10 flows through. The resistance R7 is connected between the emitter and the collector of the transistor Q4. The resistance R7 is a starting resistance.

The base electric current of the transistor Q4 is controlled by the collector of the transistor Q3, and in response to this control, the electric current from the external circuit 10 is thereby drawn to the collector of the transistor Q4 via the transmission line L1. This electric current drawn from the external circuit 10 by the transistor Q4 is electric current corresponding to the electric signal output by the sensor 101, that is, the electric current signal of 4 mA to 20 mA. By this electric current signal being output to the detection resistance R of the external circuit 10 via the transmission line L2, the external circuit 10 acquires a result of measurement of a physical quantity based on the sensor 101. This transistor Q4 corresponds to an example of a "first transistor".

As described above, the error amplifier Q2, which is an operational amplifier, generates an electric current signal that flows through the transmission line L1, by controlling electric current flowing to the transistor Q3, which is the second transistor, on the basis of input voltage. More specifically, the transistor Q3, which is the second transistor, adjusts, by means of the electric current passed by the transistor Q3, an electric current value of the electric current passed by the transistor Q4, which is the first transistor.

The reference voltage output unit 110 is connected to the signal processing circuit 102 and the reference voltage processing circuit 103. The reference voltage output unit 110 receives input of the specific electric signal from the signal processing circuit 102. The reference voltage output unit 110 then outputs a reference voltage signal for generating reference voltage of the shunt regulator circuit 105 to the reference voltage processing circuit 103, according to the specific electric signal input. The reference voltage is voltage that serves as a standard for constant voltage control by the shunt regulator circuit 105. In this embodiment, the reference voltage output unit 110 outputs, as the reference voltage signal, a reference voltage PWM signal having a duty ratio that has been changed.

The reference voltage processing circuit 103 performs predetermined processing of the reference voltage PWM signal, between the reference voltage output unit 110 and the shunt regulator circuit 105. The reference voltage processing circuit 103 has an LPF 130, an error amplifier Q5, and resistances R10 and R11.

The LPF 130 has a resistance R8 and a capacitor C1. The LPF 130 receives input of the reference voltage PWM signal from the reference voltage output unit 110. The LPF 130 smoothes the reference voltage PWM signal to convert it into an analog signal by means of the resistance R8 and the capacitor C1.

The error amplifier Q5 receives input of a signal resulting from the conversion of the reference voltage PWM signal to the analog signal, from the LPF 130. The error amplifier Q5 amplifies the signal input by negative feedback amplification using a resistance R9 and the resistance R10 and thereby generates the reference voltage. The error amplifier Q5 outputs the reference voltage to the shunt regulator circuit 105. The reference voltage will be referred to herein as the Vref.

The reference voltage processing circuit 103 may be not installed in the two-line transmitter 100 in a case where the signal processing circuit 102 has a configuration other than a configuration that outputs a PWM signal, for example, a configuration that outputs DC voltage using a DA converter.

The shunt regulator circuit 105 attempts stabilization of circuit operation by executing constant voltage control. In particular, the two-line transmitter 100 dynamically controls circuit voltage according to the electric current signal output by the two-line transmitter 100. According to the Vref, which is the reference voltage output from the error amplifier Q5, the shunt regulator circuit 105 determines the circuit voltage of the two-line transmitter 100. Sufficient consumable electric power is thereby able to be obtained in the circuitry even if the electric current (4 mA to 20 mA) supplied from the external circuit 10 is little. The shunt regulator circuit 105 has an error amplifier Q6, a transistor Q7, the resistance R11, and a resistance R12.

The Vref, which is the reference voltage input from the reference voltage processing circuit 103, is input to a noninverting input terminal of the error amplifier Q6. Voltage resulting from division of the circuit voltage by the resistance R11 and the resistance R12 is input to an inverting input terminal of the error amplifier Q6. The error amplifier Q6 detects an error between voltages input respectively to the noninverting input terminal and the inverting input terminal and performs control, together with the transistor Q7, so that these voltages agree with each other.

The transistor Q7 is a P-channel MOSFET. The smaller the electric signal output from the signal processing circuit 102, that is, the smaller the electric signal output from the sensor 101, the higher the duty ratio of the reference voltage PWM signal output by the reference voltage output unit 110. This means that the smaller the electric current supplied from the external circuit 10 is, that is, the smaller the electric current signal flowing through the transmission line L1 is, the higher the Vref, which is the reference voltage of the error amplifier Q6, becomes, and the more positive gate voltage of the transistor Q7 becomes.

That is, the smaller the electric current signal flowing through the transmission line L1 is, the smaller the electric current flowing through the transistor Q7 becomes, with the electric current being in proportion. The smaller the electric current flowing through the transistor Q7, the more reduced the voltage drop of the circuit voltage by the transistor Q7. As a result, the smaller the electric current signal flowing through the transmission line L1 is, the higher the circuit voltage becomes. The voltage input to the inverting input terminal of the error amplifier Q6 is then increased and the circuit voltage is stabilized at a time when the voltage finally becomes equal to the Vref, which is the reference voltage input to the noninverting input terminal.

Negative feedback operation by the shunt regulator circuit 105 described above is expressed by Equation 1 below.

Circuit voltage = (1 + (Resistance value of resistance R11/Resistance value of resistance R12)) × Vref          (1)

The comparator circuit 104 detects an abnormal state of the circuit voltage. The comparator circuit 104 has a comparator Q8 to detect a drop in the circuit voltage as the abnormal state.

Voltage corresponding to the reference voltage PWM signal is input to an inverting input terminal of the comparator Q8. Voltage resulting from division of the circuit voltage by the resistance R11 and the resistance R12 is input to a noninverting input terminal of the comparator Q8. The comparator Q8 compares the voltage input to the inverting input terminal with the voltage input to the noninverting input terminal, and notifies occurrence of an abnormality by inversion of output to the signal processing circuit 102 in a case where the voltage at the noninverting input terminal has dropped.

In a case where detection of an abnormality in the circuit voltage is not required, the comparator circuit 104 may be not installed in the two-line transmitter 100.

The AD conversion circuit 120 is connected to the output terminal of the error amplifier Q2 via a diagnostic line L10. The AD conversion circuit 120 receives input of voltage output from the error amplifier Q2 via the diagnostic line L10. The AD conversion circuit 120 then converts an analog signal of the voltage input, into a digital signal. Thereafter, the AD conversion circuit 120 outputs the voltage output from the error amplifier Q2 and converted into the digital signal, to the signal processing circuit 102. As described above, the AD conversion circuit 120 converts the voltage output from the error amplifier Q2, which is an operational amplifier, into the digital signal.

Failure Detection

Types of failures that are able to be detected by the two-line transmitter 100 according to the embodiment will be described next. On the basis of a change in the electric current signal flowing through the transmission line L1, the two-line transmitter 100 detects a failure. Parts of the two-line transmitter 100 may be the feedback resistance R1, the resistance R7, the transistor Q4, the transistor Q3, and the diode D2, the parts influencing the electric current signal flowing through the transmission line L1. Parts of the external circuit 10 may be the power source voltage Eb and the detection resistance R, the parts influencing the electric current signal flowing through the transmission line L1. The following description is thus on possibility of failure detection for each of these parts.

The following description is on cases where a failure occurs in the resistance R7. In a case where a failure, in which the resistance R7 decreases in resistance value, occurs, electric current larger than the control electric current flows as the electric current signal flowing through the transmission line L1. In this case, the voltage output from the error amplifier Q2 will have a value stuck to the circuit common voltage, which is the lower limit, or a value around the circuit common voltage. Therefore, the signal processing circuit 102 is able to detect occurrence of the failure and is able to notify the external circuit 10 of the failure, because the signal processing circuit 102 is able to verify that the voltage value of the electric current signal actually flowing through the transmission line L1 is smaller than the lower limit sticking determination value for the control electric current.

In a case where a failure, in which the resistance R7 shorts out, occurs, electric current larger than the control electric current flows as the electric current signal flowing through the transmission line L1. In this case, the voltage output from the error amplifier Q2 will have a value stuck to the circuit common voltage, which is the lower limit, or a value around the circuit common voltage. Therefore, the signal processing circuit 102 is able to detect occurrence of the failure because the signal processing circuit 102 is able to verify that the voltage value of the electric current signal actually flowing through the transmission line L1 is smaller than the lower limit sticking determination value for the control electric current.

In a case where a failure, in which the resistance value of the resistance R7 increases or the resistance R7 becomes open, occurs, the electric current flowing through the resistance R7 decreases. In this case, the signal processing circuit 102 is able to match the electric current signal flowing through the transmission line L1 to the control electric current by passing more electric current to the transistor Q4. Therefore, the signal processing circuit 102 is able to notify the external circuit 10 of a correct physical quantity.

Cases where a failure occurs in the transistor Q4 will be described next. In a case where a failure, in which electric current equal to or larger than the control electric current flows through the transmission line L1, occurs in the transistor Q4, electric current larger than control electric current flows as the electric current signal flowing through the transmission line L1. In this case, the voltage output from the error amplifier Q2 will have a value stuck to the circuit common voltage, which is the lower limit, or a value around the circuit common voltage. Therefore, the signal processing circuit 102 is able to detect occurrence of the failure and is able to notify the external circuit 10 of the failure, because the signal processing circuit 102 is able to verify that the voltage value of the electric current signal actually flowing through the transmission line L1 is smaller than the lower limit sticking determination value for the control electric current.

In a case where a failure, in which electric current equal to or smaller than the control electric current flows through the transmission line L1, occurs in the transistor Q4, electric current less than the control electric current flows as the electric current signal flowing through the transmission line L1. In this case, the voltage output from the error amplifier Q2 will have a value stuck to the circuit voltage, which is the upper limit, or a value around the circuit voltage. Therefore, the signal processing circuit 102 is able to detect occurrence of the failure and is able to notify the external circuit 10 of the failure, because the signal processing circuit 102 is able to verify that the voltage value of the electric current signal actually flowing through the transmission line L1 is larger than the upper limit sticking determination value for the control electric current.

Cases where a failure occurs in the transistor Q3 will be described next. For the transistor Q3 also, a failure, in which electric current equal to or larger than the control electric current flows through the transmission line L1, and a failure, in which electric current equal to or smaller than the control electric current flows therethrough, may occur. In both of these cases, the signal processing circuit 102 operates similarly to the cases for the transistor Q4 and is able to detect occurrence of the failures and notify the external circuit 10 of the failures.

In a case where a failure, in which the feedback resistance R1 becomes open, occurs, electric current less than the control electric current flows as the electric current signal flowing through the transmission line L1. In this case, the voltage output from the error amplifier Q2 will have a value stuck to the circuit voltage, which is the upper limit, or a value around the circuit voltage. Therefore, the signal processing circuit 102 is able to detect occurrence of the failure and is able to notify the external circuit 10 of the failure, because the signal processing circuit 102 is able to verify that the voltage value of the electric current signal actually flowing through the transmission line L1 is larger than the upper limit sticking determination value for the control electric current.

In a case where a failure, in which the feedback resistance R1 shorts out, occurs, electric current larger than the control electric current flows as the electric current signal flowing through the transmission line L1. In this case, the error amplifier Q2 attempts to increase the output electric current and the voltage output thus will have a value stuck to the circuit voltage, which is the upper limit, or a value around the circuit voltage. Therefore, the signal processing circuit 102 is able to detect occurrence of the failure because the signal processing circuit 102 is able to verify that the voltage value of the electric current signal actually flowing through the transmission line L1 is larger than the upper limit sticking determination value for the control electric current.

Cases where a failure occurs in the power source voltage Eb will be described next. In a case where a failure, in which the power source voltage Eb increases, occurs, the electric current of the electric current signal flowing through the transmission line L1 is larger than the control electric current, the electric current signal being determined from the power source voltage Eb, the resistance R7, and the feedback resistance R1. In this case, the voltage output from the error amplifier Q2 will have a value stuck to the circuit common voltage, which is the lower limit, or a value around the circuit common voltage. Therefore, the signal processing circuit 102 is able to detect occurrence of the failure and is able to notify the external circuit 10 of the failure, because the signal processing circuit 102 is able to verify that the voltage value of the electric current signal actually flowing through the transmission line L1 is smaller than the lower limit sticking determination value for the control electric current.

In a case where a failure, in which the power source voltage Eb drops, occurs, the drop in the power source voltage Eb decreases the voltage between the collector and emitter of the transistor Q4 and the electric current of the electric current signal flowing through the transmission line L1 thereby becomes smaller than the control electric current. In this case, the voltage output from the error amplifier Q2 will have a value stuck to the circuit voltage, which is the upper limit, or a value around the circuit voltage. Therefore, the signal processing circuit 102 is able to detect occurrence of the failure and is able to notify the external circuit 10 of the failure, because the signal processing circuit 102 is able to verify that the voltage value of the electric current signal actually flowing through the transmission line L1 is larger than the lower limit sticking determination value for the control electric current.

Cases where a failure occurs in the detection resistance R will be described next. For the detection resistance R, similarly to the power source voltage Eb, a case where electric current equal to or larger than the control electric current flows through the transmission line L1, and a case where electric current equal to or smaller than the control electric current flows therethrough may be considered. In both of these cases, the signal processing circuit 102 operates similarly to the cases for the power source voltage Eb, and is able to detect occurrence of the failures and notify the external circuit 10 of the failures.

Examples

Failure detection by the two-line transmitter 100 according to the embodiment will be described next by use of specific numerical values. Relevant parameters are set herein as follows. The gain of the error amplifier Q2 is 1000 times. The feedback resistance R1 has a resistance value of 100 $\Omega$. The resistances R3 to R6 all have a resistance value of 100 k$\Omega$. The voltage of the reference voltage source P1 is 0.2 V. An indicated voltage, which is a voltage output from the error amplifier Q2 according to a physical quantity acquired from the sensor 101, is 1.4 V.

As described above, the error amplifier Q2 detects the error between the voltage resulting from the division of the voltage output by the error amplifier Q2 by the feedback resistance R1 and the resistances R3 and R4 and the voltage resulting from the division of the output voltage of the reference voltage source P1 by the resistances R5 and R6. On the basis of the error detected, the error amplifier Q2 then controls the electric current flowing to the transistors Q3 and Q4 so that the two voltages input agree with each other. Therefore, the voltage at the inverting input terminal and the voltage at the noninverting input terminal of the error amplifier Q2 become the same.

Using the parameters described above, the electric current value of the electric current signal in a case where a failure has not occurred is calculated. The voltage at the inverting input terminal of the error amplifier Q2 can be found by Equation 2 below.

Voltage at inverting input terminal of error amplifier Q2 = Voltage of reference voltage source P1 $\times$ Resistance value of resistance R6/(Resistance value of resistance R6 + Resistance value of resistance R7) (2)     (2)

Accordingly, in the case with the parameters described above, the voltage at the inverting input terminal of the error amplifier Q2 is found to be 0.1 V.

The feedback voltage generated across the feedback resistance R1 can be found by Equation 3 below.

Feedback voltage generated across feedback resistance R1 = Negative terminal voltage of error amplifier Q2 - ((Indicated voltage - Voltage at inverting input terminal of error amplifier Q2)/Resistance value of resistance R3) × Resistance value of resistance R4 (3)                                                                        (3)

Accordingly, in the case with the parameters described above, the feedback voltage generated across the feedback resistance R1 is found to be -1.2 V.

The electric current value of the electric current signal can be found by Equation 4 below.

Electric current value of electric current signal = Feedback voltage generated across feedback resistance R1/Resistance value of resistance R3 (4)                                                                                    (4)

Accordingly, in the case with the parameters described above, the electric current value of the electric current signal is found to be 12 mA.

A case where a specific failure has occurred and the electric current signal has changed to 13 mA will be described next. In this case, the feedback voltage generated across the feedback resistance R1 is found to be -1.3 V. The voltage at the noninverting input terminal of the error amplifier Q2 can be found by Equation 5 below.

Voltage at noninverting input terminal of error amplifier Q2 = Feedback voltage generated across feedback resistance R1 + (Indicated voltage - Feedback voltage generated across feedback resistance R1) × Resistance value of resistance R4/(Resistance value of resistance R3/Resistance value of resistance R4) (5)                        (5)

Accordingly, in the case with the parameters described above, the voltage at the noninverting input terminal of the error amplifier Q2 is found to be 0.05 V. The output voltage of the error amplifier Q2 is calculated as the voltage at the noninverting input terminal of the error amplifier Q2 - the voltage at the inverting input terminal of the error amplifier Q2 = -50 V, but the output voltage of the error amplifier Q2 actually becomes the circuit common voltage, which is the lower limit.

As described above, in response to a flow of electric current larger than the set electric current, the output voltage from the error amplifier Q2 becomes a value stuck to the circuit common voltage, which is the lower limit, or a value around the circuit common voltage, and the signal processing circuit 102 is thus able to detect an abnormality, in which the electric current increases, by monitoring the output voltage of the error amplifier Q2. By setting the electric current value of the electric current signal to a value outside and larger than the normal range, the signal processing circuit 102 is able to notify the external circuit 10 of the abnormality as a failure. The case where the electric current value of the electric current signal becomes larger than the control electric current has been described herein, but in a case where the electric current value of the electric current signal becomes smaller than the control electric current also, the two-line transmitter 100 operates similarly, with the polarity inverted.

Flow of Failure Detection Process

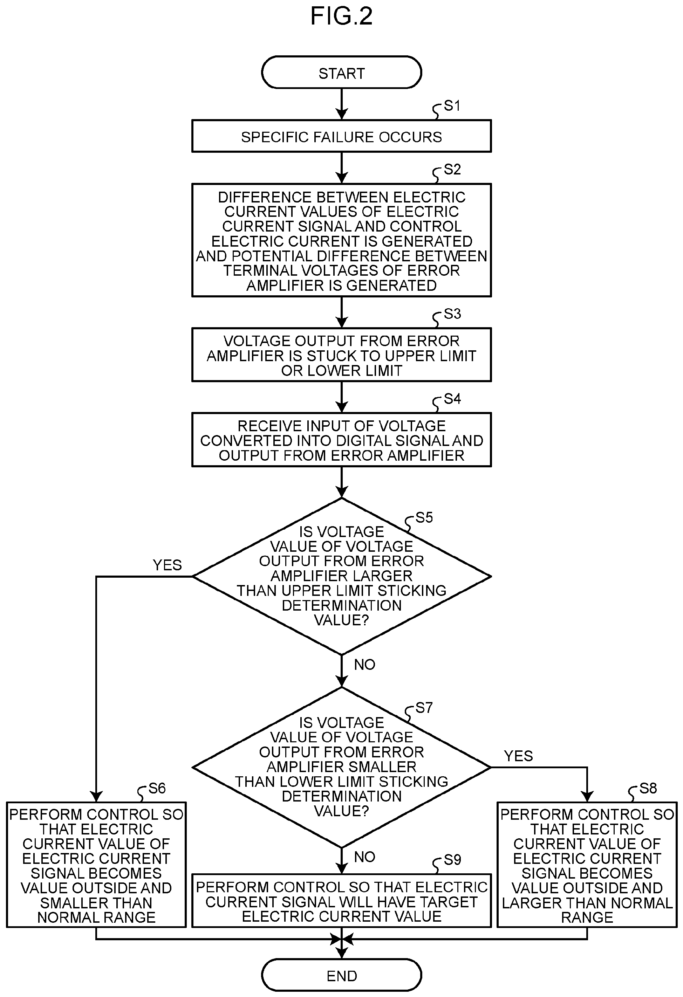

FIG. 2 is a flowchart of a failure detection process by the two-line transmitter according to the first embodiment. A flow of a failure detection process by the two-line transmitter 100 according to this embodiment will be described next by reference to FIG. 2.

A specific failure, such as a reduction in the resistance value of the resistance R7 or a flow of electric current larger than the control electric current to the transistor Q4, occurs in the two-line transmitter 100 (Step S1).

A difference between electric current values of the electric current signal flowing through the transmission line L1 and the control electric current is generated, and a potential difference is generated between the voltage at the inverting input terminal of the error amplifier Q2 and the voltage at the noninverting input terminal of the error amplifier Q2 (Step S2).

The voltage value of the voltage output from the error amplifier Q2 becomes a value stuck to the circuit voltage, which is the upper limit, a value stuck to the circuit common voltage, which is the lower limit, or a value around the circuit voltage or circuit common voltage (Step S3).

The signal processing circuit 102 receives input of the voltage output from the error amplifier Q2, the voltage having been converted into a digital signal by the AD conversion circuit 120 (Step S4).

Subsequently, the signal processing circuit 102 determines whether or not the voltage value of the voltage output from the error amplifier Q2 is larger than the upper limit sticking determination value (Step S5). Specifically, in a case where the voltage value of the voltage output from the error amplifier Q2 is around the circuit voltage, which is the upper limit, the signal processing circuit 102 determines that the voltage value of the voltage output from the error amplifier Q2 is larger than the upper limit sticking determination value. That is, the signal processing circuit 102 determines that the voltage value of the voltage output from the error amplifier Q2 is stuck to the circuit voltage.

In a case where the voltage value of the voltage output from the error amplifier Q2 is larger than the upper limit sticking determination value (Step S5: Yes), the signal processing circuit 102 performs control so that the electric current value of the electric current signal becomes a value outside and smaller than the normal range (Step S6). The signal processing circuit 102 thereby notifies the external circuit 10 of the failure.

In a case where the voltage value of the voltage output from the error amplifier Q2 is equal to or smaller than the upper limit sticking determination value (Step S5: No), the signal processing circuit 102 determines whether or not the voltage value of the voltage output from the error amplifier Q2 is smaller than the lower limit sticking determination value (Step S7). Specifically, in a case where the voltage value of the voltage output from the error amplifier Q2 is around the circuit common voltage, which is the lower limit, the signal processing circuit 102 determines that the voltage value of the voltage output from the error amplifier Q2 is smaller than the lower limit sticking determination value. That is, the signal processing circuit 102 determines that the voltage value of the voltage output from the error amplifier Q2 is stuck to the circuit common voltage.

In a case where the voltage value of the voltage output from the error amplifier Q2 is smaller than the lower limit sticking determination value (Step S7: Yes), the signal processing circuit 102 performs control so that the electric current value of the electric current signal becomes a value outside and larger than the normal range (Step S8). The signal processing circuit 102 thereby notifies the external circuit 10 of the failure.

This determination based on the upper limit sticking determination value or lower limit sticking determination value for the voltage output from the error amplifier Q2 corresponds to an example of "a comparison between a voltage value of voltage output from an error amplifier and a determination voltage value".

In contrast, in a case where the voltage value of the voltage output from the error amplifier Q2 is equal to or larger than the lower limit sticking determination value (Step S7: No), the signal processing circuit 102 performs control so that the electric current signal will have the target electric current value (Step S9). Operation of the signal processing circuit 102 in this case is normal operation.

Effects

As described above, the two-line transmitter 100 according to the embodiment monitors changes in the voltage output from the error amplifier Q2 and detects that a voltage value of the voltage output from the error amplifier Q2 upon occurrence of a specific failure is stuck to the upper limit or the lower limit. The two-line transmitter 100 according to the embodiment thereby detects the failure and makes a notification of the failure.

In a case where an abnormality, in which the electric current signal differs from a setting due to a failure in the circuitry of the two-line transmitter 100 or a power source voltage shortage in the two-line transmitter 100, occurs, the abnormality is thereby able to be communicated to the external circuit 10. Reliability of the two-line transmitter 100 is thereby able to be improved and contribution to stable operation of the plant is thus enabled.

As a simple method for detecting an abnormality, in which the electric current signal differs from a setting due to a failure in the circuitry or a power source voltage shortage, a method of directly measuring the electric current flowing to the feedback resistance R1 may be considered. However, the two-line transmitter 100 according to the embodiment enables the abnormality to be detected with a circuit configuration simpler than that in the method of directly measuring the electric current flowing to the feedback resistance R1. Therefore, the two-line transmitter 100 according to the embodiment has advantages of cost reduction for the components, low electric current consumption, and reduction in difficulty of designing the substrate wiring. For example, there is a demand for lower electric current consumption because the electric current flowing into the two-line transmitter 100 is small, and the two-line transmitter 100 according to the embodiment is able to meet this demand.

Modified Example

A modified example of the two-line transmitter 100 according to the first embodiment will be described next. A signal processing circuit 102 according to this modified example has an AD conversion circuit. In this modified example, the AD conversion circuit 120 may be not installed in a two-line transmitter 100.

The signal processing circuit 102 is connected to an output terminal of an error amplifier Q2 via a diagnostic line L10. The signal processing circuit 102 receives input of voltage output from the error amplifier Q2. The signal processing circuit 102 then converts an analog signal of the voltage input using the AD conversion circuit that the signal processing circuit 102 has, into a digital signal.

Thereafter, the signal processing circuit 102 makes a determination on whether the voltage output from the error amplifier Q2 has a voltage value larger than an upper limit sticking determination value or smaller than a lower limit sticking determination value, performs, on the basis of a result of the determination, control so that an electric current value of an electric current signal becomes a value outside a normal range, and notifies an external circuit 10 of a failure. As described above, the signal processing circuit 102 according to the embodiment makes a conversion of the voltage output from the error amplifier Q2, which is an operational amplifier, into a digital signal, and detects a failure on the basis of the digital signal resulting from the conversion.

Effects

As described above, the signal processing circuit 102 having the AD conversion circuit may be used. In this case, the AD conversion circuit 120 is able to be omitted, and the area for mounting the components and cost of the components are thus able to be reduced.

Second Embodiment

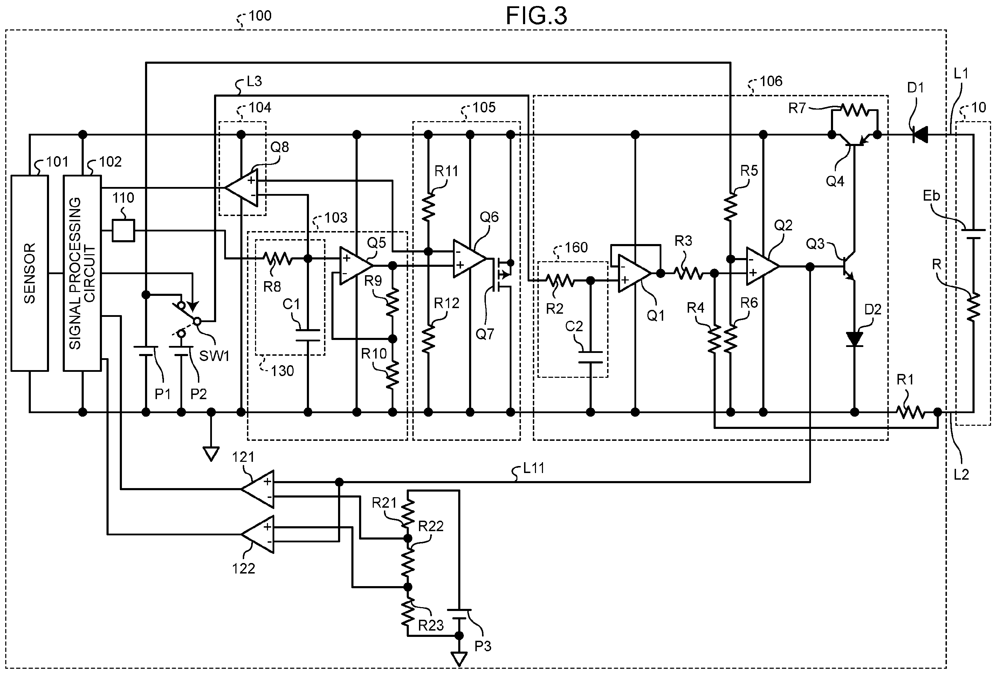

FIG. 3 is a circuit diagram of a two-line transmitter according to a second embodiment. A two-line transmitter 100 according to this embodiment notifies a signal processing circuit 102 of information on a voltage value of voltage output from an error amplifier Q2 by using comparators 121 and 122 instead of the AD conversion circuit 120 in the first embodiment. Description of operation of any component that is the same as that according to the first embodiment will hereinafter be omitted.

A noninverting input terminal of the comparator 121 is connected to a connection path between the error amplifier Q2 and a transistor Q3 via a diagnostic line L11. An inverting input terminal of the comparator 121 is connected to a connection point between a resistance R21 and a resistance R22 of the resistances R21 and R21 and a resistance R23, which are connected in series between an input and an output of a reference voltage source P3. An output terminal of the comparator 121 is connected to the signal processing circuit 102.

The comparator 121 receives input of the voltage output by the error amplifier Q2. The comparator 121 then compares the voltage value of the voltage input with a voltage value resulting from division of voltage from the reference voltage source P3 by the resistance R21 and the resistances R22 and R23. In a case where the voltage value of the voltage input is equal to or larger than the voltage value resulting from the division of the voltage from the reference voltage source P3, the comparator 121 outputs "1". In a case where the voltage value of the voltage input is smaller than the voltage value resulting from the division of the voltage from the reference voltage source P3, the comparator 121 outputs "0".

That is, in the case where the voltage value of the voltage input is equal to or larger than the voltage value resulting from the division of the voltage from the reference voltage source P3, the comparator 121 determines that the voltage output by the error amplifier Q2 is stuck to a circuit voltage, which is an upper limit, and outputs "1". In the case where the voltage value of the voltage input is smaller than the voltage value resulting from the division of the voltage from the reference voltage source P3, the comparator 121 determines that the voltage output by the error amplifier Q2 is within a normal range or is stuck to a circuit common voltage, which is a lower limit, and outputs "0". This comparator 121 corresponds to an example of a "first comparator". The voltage value resulting from the division of the voltage from the reference voltage source P3 corresponds to an example of an "upper limit threshold". The comparator 121 determines whether the voltage output from the error amplifier Q2, which is an operation amplifier, is equal to or larger than the upper limit threshold.

An inverting input terminal of the comparator 122 is connected to a connection path between the error amplifier Q2 and the transistor Q3 via the diagnostic line L11. A noninverting input terminal of the comparator 122 is connected to a connection point between the resistance R22 and the resistance R23 of the resistances R21 to R23 connected in series between the input and the output of the reference voltage source P3. An output terminal of the comparator 122 is connected to the signal processing circuit 102.

The comparator 122 receives input of the voltage output by the error amplifier Q2. The comparator 122 then compares the voltage value of the voltage input with a voltage value resulting from division of the voltage from the reference voltage source P3 by the resistances R21 and R22 and the resistance R23. In a case where the voltage value of the voltage input is equal to or larger than the voltage value resulting from the division of the voltage from the reference voltage source P3, the comparator 122 outputs "0". In a case where the voltage value of the voltage input is smaller than the voltage value resulting from the division of the voltage from the reference voltage source P3, the comparator 122 outputs "1".

That is, in the case where the voltage value of the voltage input is equal to or larger than the voltage value resulting from the division of the voltage from the reference voltage source P3, the comparator 122 determines that the voltage output by the error amplifier 2 is within the normal range or is stuck to the circuit voltage, which is the upper limit, and outputs "0". In the case where the voltage value of the voltage input is smaller than the voltage value resulting from the division of the voltage from the reference voltage source P3, the comparator 122 determines that the voltage output by the error amplifier 2 is stuck to the circuit common voltage, which is the lower limit, and outputs "1". This comparator 122 corresponds to an example of a "second comparator". The voltage value resulting from the division of the voltage from the reference voltage source P3 corresponds to an example of a "lower limit threshold". The comparator 122 determines whether the voltage output from the error amplifier Q2, which is an operation amplifier, is smaller than the lower limit threshold.

In this embodiment, a logic to output "1" upon an abnormality is used for both of the comparators 121 and 122, but any configuration that enables a notification of an abnormality in a case where sticking to the circuit voltage or circuit common voltage has been detected may be used, instead of the logic to output "1" upon an abnormality.

The signal processing circuit 102 receives input of an output signal from each of the comparators 121 and 122. In a case where the output signal from the comparator 121 is "1", the signal processing circuit 102 performs control so that the electric current value of the electric current signal becomes a value outside and smaller than the normal range. In a case where the output signal from the comparator 122 is "1", the signal processing circuit 102 performs control so that the electric current value of the electric current signal becomes a value outside and larger than the normal range. The signal processing circuit 102 thereby notifies an external circuit 10 of the failure.

Effects

As described above, the two-line transmitter 100 according to this embodiment detects a failure from information on the voltage output by the error amplifier Q2, by using the comparators 121 and 122 instead of the AD conversion circuit 120. The two-line transmitter 100 then causes the signal processing circuit 102 to adjust the electric current value of the electric current signal on the basis of a result of the detection of the failure by the comparators 121 and 122 and makes a notification of the failure. Complicated processing by the AD conversion circuit 120 is thereby able to be simplified, detection of a failure is enabled by a simple configuration, cost of the components is able to be reduced, and difficulty of designing of the substrate wiring is able to be reduced.

Third Embodiment

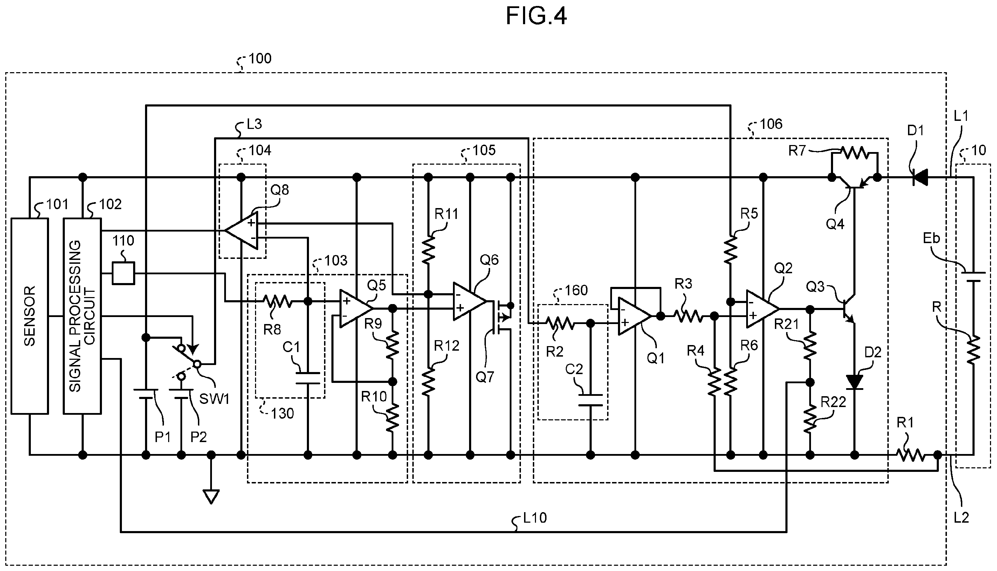

FIG. 4 is a circuit diagram of a two-line transmitter according to a third embodiment. A two-line transmitter 100 according to this embodiment does not have the AD conversion circuit 120 and a signal processing circuit 102 thereof does not have an AD conversion circuit either. The two-line transmitter 100 according to the embodiment having such a configuration detects sticking of voltage value of voltage output from an error amplifier Q2 to a circuit voltage, which is an upper limit. Description of operation of any component that is the same as that according to the first embodiment will hereinafter be omitted.

A path connecting an output terminal of the error amplifier Q2 and a base of a transistor Q3 to each other is connected to a transmission line L2 via resistances R21 and R22 arranged in series.

The signal processing circuit 102 is connected to a connection point between the resistance R21 and R22 via a diagnostic line L10. The signal processing circuit 102 receives, as an analog signal as is, input of a voltage value resulting from division of the voltage value of the voltage output from the error amplifier Q2 by the resistances R21 and R22, from the diagnostic line L10.

The signal processing circuit 102 has a voltage threshold beforehand for detecting sticking of the voltage value to the circuit voltage, which is the upper limit. This voltage threshold may be the same as the upper limit sticking threshold according to the first embodiment. By using the voltage input from the diagnostic line L10 as the analog signal as is, the signal processing circuit 102 determines whether or not the voltage value of that voltage exceeds the voltage threshold. In a case where the voltage value of the voltage input from the diagnostic line L10 exceeds the voltage threshold, the signal processing circuit 102 determines that the voltage value of the voltage output from the error amplifier Q2 is stuck to the circuit voltage, which is the upper limit, and performs control so that an electric current value of an electric current signal becomes a value outside and smaller than a normal range. The signal processing circuit 102 thereby notifies an external circuit 10 of a failure.

As described above, the signal processing circuit 102 according to the embodiment receives input of voltage that is an analog signal output from the error amplifier Q2, which is an operational amplifier, and compares a voltage value of the voltage that is the analog signal acquired, with a predetermined threshold voltage value. In a case where the voltage value of the voltage is equal to or larger than the threshold voltage value, the signal processing circuit 102 detects a failure.

Effects

As described above, the two-line transmitter 100 according to the embodiment thereby enables detection and notification of a failure without use of an AD conversion function. The area for mounting the components and cost of the components are thereby able to be reduced.

Fourth Embodiment

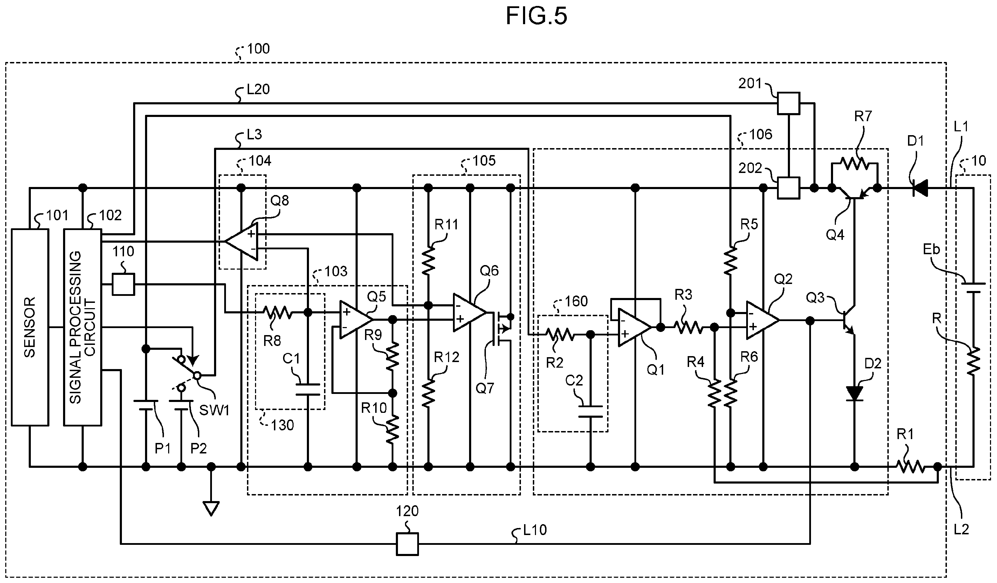

FIG. 5 is a circuit diagram of a two-line transmitter according to a fourth embodiment. A two-line transmitter 100 according to the embodiment notifies an external circuit 10 of a failure by turning off power by means of a shutdown circuit 201 and stopping operation of the two-line transmitter 100. Description of operation of any component that is the same as that according to the second embodiment will hereinafter be omitted. The two-line transmitter 100 according to this embodiment has the shutdown circuit 201 and a switch 202.

A signal processing circuit 102 determines whether or not a failure has occurred by comparing a voltage value of voltage output from an error amplifier Q2 with an upper limit sticking determination value and a lower limit sticking determination value. In a case where the signal processing circuit 102 determines that a failure has occurred, the signal processing circuit 102 transmits a notification of occurrence of the failure to the shutdown circuit 201.

The switch 202 is a switch for stopping supply of electric power to the signal processing circuit 102 and a constant current circuit 106, for example. In this embodiment, the switch 202 is arranged on a transmission line L1, and stops the supply of electric power to the signal processing circuit 102 and the constant current circuit 106, for example, by disconnecting the transmission line L1.

The shutdown circuit 201 is connected to the signal processing circuit 102 by a communication line L20. The shutdown circuit 201 is connected to the switch 202. The shutdown circuit 201 operates by receiving supply of electric power from a power source different from that of the signal processing circuit 102 and the constant current circuit 106, for example.

The shutdown circuit 201 receives the notification of the occurrence of the failure from the signal processing circuit 102. Upon receipt of the notification of the occurrence of the failure, the shutdown circuit 201 operates the switch 202 to disconnect the transmission line L1. The two-line transmitter 100 thereby stops operation of transmitting a signal representing a physical quantity. The shutdown circuit 201 has a latch function and maintains the switch 202 in a disconnected state even after the signal processing circuit 102 has stopped operation, to keep stopping the supply of electric power from the power source. In response to the two-line transmitter 100 stopping the operation of transmitting the signal representing the physical quantity, the external circuit 10 determines that an electric current value of signal electric current has become 0 and detects the failure in the two-line transmitter 100.

As described above, in a case where the signal processing circuit 102 detects a failure, the signal processing circuit 102 notifies the shutdown circuit 201 of the detection of the failure. Upon receipt of the notification of the detection of the failure from the signal processing circuit 102, the shutdown circuit 201 makes a notification of the failure by stopping supply of electric power to the signal processing circuit, to stop operation.

Effects

As described above, the two-line transmitter 100 according to this embodiment makes a notification of occurrence of a failure by stopping supply of electric power to the signal processing circuit 102 and the constant current circuit 106, for example, by using the shutdown circuit 201, to stop operation of transmitting a signal representing a physical quantity. The two-line transmitter 100 stopping its operation upon the failure enables reduction of electric power consumption.

Fifth Embodiment

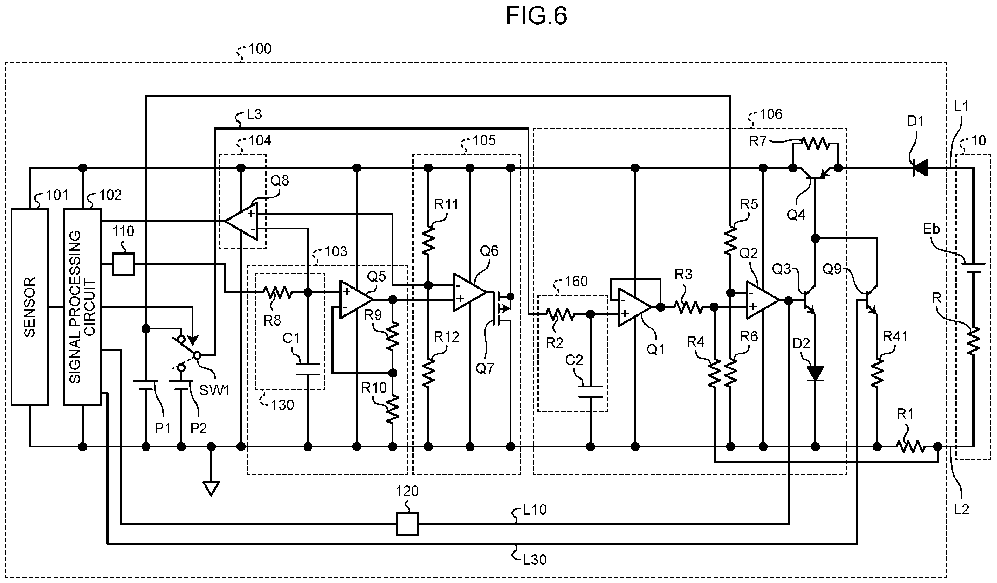

FIG. 6 is a circuit diagram of a two-line transmitter according to a fifth embodiment. A two-line transmitter 100 according to this embodiment has a transistor Q9 added in parallel with a transistor Q3 and a diode D2 and makes a notification of a failure also upon a failure in the transistor Q3 or the diode D2. Description of operation of any component that is the same as that according to the second embodiment will hereinafter be omitted. The two-line transmitter 100 according to this embodiment has the transistor Q9 and a resistance R41.

A path branching off from a path joining a collector of the transistor Q3 and a base of a transistor Q4 is connected to a collector of the transistor Q9. A signal processing circuit 102 is connected to a base of the transistor Q9 via a diagnostic line L30. An emitter of the transistor Q9 is connected to the resistance R41.

This transistor Q9 corresponds to an example of a "third transistor". The transistor Q9 is arranged in parallel with the transistor Q3, which is a second transistor, and adjusts, by means of electric current that the transistor Q9 passes, an electric current value of electric current passed by the transistor Q4, which is a first transistor.

One end of the resistance R41 is connected to the emitter of the transistor Q9. The other end of the resistance R41 is connected to a transmission line L2.

The signal processing circuit 102 operates as follows. For example, in a case where a failure, in which control of the transistor Q3 fails and an amount of electric current passed by the transistor Q3 is decreased, occurs, voltage output from an error amplifier Q2 will be at a value stuck to a circuit voltage, which is an upper limit, or a value around the circuit voltage. In this case, the signal processing circuit 102 determines that the voltage output from the error amplifier Q2 has a voltage value larger than an upper limit sticking determination value. In this case, by decreasing electric current flowing to the transistor Q9, the signal processing circuit 102 performs control so that an electric current value of an electric current signal becomes a value outside and smaller than a normal range to notify an external circuit 10 of the failure.

Similarly, in a case where a failure occurs in the diode D2 and no electric current flows through the diode D2, the signal processing circuit 102 is able to notify the external circuit 10 of the failure.

Furthermore, for example, in a case where a failure, in which control of the transistor Q3 fails and an amount of electric current passed by the transistor Q3 is increased, occurs, voltage output from the error amplifier Q2 will be at a value stuck to a circuit common voltage, which is a lower limit, or a value around the circuit common voltage. In this case, the signal processing circuit 102 determines that the voltage output from the error amplifier Q2 has a voltage value smaller than a lower limit sticking determination value. In this case also, by increasing electric current flowing to the transistor Q9, the signal processing circuit 102 performs control so that the electric current signal has an electric current value outside and larger than the normal range to notify the external circuit 10 of the failure.

The signal processing circuit 102 thus operates as follows in a case where the signal processing circuit 102 has detected a failure on the basis of a voltage value of voltage output from the error amplifier Q2, which is an operational amplifier, according to a failure in the transistor Q3, which is the second transistor. The signal processing circuit 102 controls electric current passed by the transistor Q9, which is the third transistor, to control input voltage to the error amplifier Q2 so that an electric current value of an electric current signal becomes a predetermined value, and thereby makes a notification of the failure.

Effects

As described above, the two-line transmitter 100 according to this embodiment is able to notify the external circuit 10 of a failure by causing an electric current signal to be outside the normal range even in a case where the failure occurs in the transistor Q3 or the diode D2. Coverage of the failure detection is thereby able to be improved.

Failure detection and notification have been described above with the two-line transmitter 100 serving as an example, but any other device with a constant current circuit using an operational amplifier like the constant current circuit 106 may implement the failure detection and notification with a similar configuration.

A device with a constant current circuit using an operational amplifier desirably has at least an error amplifier Q2, a transistor Q4, a transistor Q3, a feedback resistance R1, a resistance R3, and a resistance R4. Any device with a configuration having these components enables control of electric current. Inputting information on voltage output from the error amplifier Q2 to the signal processing circuit 102 enables the signal processing circuit 102 to implement failure detection and notification for that device. For example, if the signal processing circuit 102 is capable of outputting analog voltage, operation is enabled by input of output from the signal processing circuit 102 to the resistance R3.

The two-line transmitter 100 described with respect to each of the embodiments may be modified as follows. For example, the resistance R7 may be replaced with an active circuit. The resistances R6 and R7 are used as biases to be connected to the transmission line L2 and may be directly connected to a ground. The buffer amplifier Q1 and the LPF 160 change the PWM signal to analog voltage and may be replaced with a DA converter.

Any processing steps, control steps, specific names, and information including various data and parameters, which have been described above and illustrated in the drawings may be optionally modified unless particularly stated otherwise.

Furthermore, the components of each device in the drawings have been illustrated functionally and/or conceptually, and do not need to be physically configured as illustrated in the drawings. That is, specific modes of separation and integration of each device are not limited to those illustrated in the drawings. That is, all or part of each device may be configured to be functionally or physically separated or integrated in any units according to various loads and use situations.

The following description is on some examples of a combination of technical features disclosed herein.

The present invention enables improvement in reliability of a constant current device by detecting an abnormal difference between an electric current value of an electric current signal that actually flows and a set electric current value.

Although the invention has been described with respect to specific embodiments for a complete and clear disclosure, the appended claims are not to be thus limited but are to be construed as embodying all modifications and alternative constructions that may occur to one skilled in the art that fairly fall within the basic teaching herein set forth.

**Claims**

1. A constant current device, comprising:

   an error amplifier that generates an electric current signal that is constant electric current; and
   a signal processing circuit that inputs input voltage for generating the electric current signal having a target electric current value to the error amplifier and detects a failure by comparing a voltage value of voltage output from the error amplifier with a determination voltage value.

2. The constant current device according to claim 1, wherein in a case where the signal processing circuit detects a failure, the signal processing circuit makes a notification of occurrence of the failure by controlling the input voltage so that the electric current signal will have an electric current value at a value outside a predetermined normal range.

3. The constant current device according to claim 1 or 2, further including:

a first transistor arranged on a transmission line for the electric current signal;
a second transistor that adjusts, by means of electric current that the second transistor passes, an electric current value of electric current passed by the first transistor;
a feedback resistance arranged on the transmission line; and
a first resistance and a second resistance that adjust, on the basis of voltage based on a potential difference across the feedback resistance, the input voltage so as to bring an electric current value of the electric current signal closer to the target electric current value, wherein
the error amplifier generates, on the basis of the input voltage, the electric current signal flowing through the transmission line by controlling electric current flowing to the second transistor.

4. The constant current device according to claim 3, further including:

a third transistor that adjusts, by means of electric current that the third transistor passes, the electric current value of the electric current passed by the first transistor, the third transistor having been arranged in parallel with the second transistor, wherein
in a case where the signal processing circuit detects a failure on the basis of the voltage value of the voltage output from the error amplifier according to a failure in the second transistor, the signal processing circuit makes a notification of occurrence of the failure by controlling the input voltage so that the electric current value of the electric current signal becomes a predetermined value through control of the electric current passed by the third transistor.

5. The constant current device according to any one of claims 1 to 4, further including:

an AD conversion circuit that converts the voltage output from the error amplifier into a digital signal, wherein the signal processing circuit detects occurrence of a failure on the basis of the digital signal input from the AD conversion circuit.

6. The constant current device according to any one of claims 1 to 4, wherein the signal processing circuit converts the voltage output from the error amplifier into a digital signal and detects a failure on the basis of the digital signal converted.

7. The constant current device according to any one of claims 1 to 4, further including:

a first comparator that makes a determination on whether the voltage output from the error amplifier is equal to or larger than an upper limit threshold; and
a second comparator that makes a determination on whether the voltage output from the error amplifier is smaller than a lower limit threshold, wherein
the signal processing circuit detects a failure on the basis of results of the determinations by the first comparator and the second comparator.

8. The constant current device according to any one of claims 1 to 4, wherein the signal processing circuit receives input of voltage that is an analog signal output from the error amplifier, compares a voltage value of the voltage that is the analog signal acquired, with a predetermined threshold voltage value, and detects a failure in a case where the voltage value of the voltage is equal to or larger than the predetermined threshold voltage value.

9. The constant current device according to any one of claims 1 to 8, further including:

a shutdown circuit that makes a notification of a failure by stopping supply of electric power to the signal processing circuit and stopping operation, upon receipt of a notification of detection of the failure from the signal processing circuit, wherein
in a case where the failure is detected, the signal processing circuit notifies the shutdown circuit of the detection of the failure.

**10.** A failure detection method for a constant current circuit including an error amplifier that generates an electric current signal that is constant electric current, wherein a signal processing circuit executes:

inputting input voltage for generating the electric current signal having a target electric current value to the error amplifier; and
detecting a failure by comparing a voltage value of voltage output from the error amplifier with a determination voltage value.

# FIG.1

SENSOR

SIGNAL PROCESSING CIRCUIT

# FIG.2

```
                    START

                      │
                      ▼                    S1
    ┌─────────────────────────────────────┐
    │      SPECIFIC FAILURE OCCURS         │
    └─────────────────────────────────────┘
                      │
                      ▼                    S2
    ┌─────────────────────────────────────┐
    │  DIFFERENCE BETWEEN ELECTRIC         │
    │  CURRENT VALUES OF ELECTRIC          │
    │  CURRENT SIGNAL AND CONTROL          │
    │  ELECTRIC CURRENT IS GENERATED       │
    │  AND POTENTIAL DIFFERENCE BETWEEN    │
    │  TERMINAL VOLTAGES OF ERROR          │
    │  AMPLIFIER IS GENERATED              │
    └─────────────────────────────────────┘
                      │
                      ▼                    S3
    ┌─────────────────────────────────────┐
    │  VOLTAGE OUTPUT FROM ERROR           │
    │  AMPLIFIER IS STUCK TO UPPER LIMIT   │
    │  OR LOWER LIMIT                      │
    └─────────────────────────────────────┘
                      │
                      ▼                    S4
    ┌─────────────────────────────────────┐
    │  RECEIVE INPUT OF VOLTAGE            │
    │  CONVERTED INTO DIGITAL SIGNAL AND   │
    │  OUTPUT FROM ERROR AMPLIFIER         │
    └─────────────────────────────────────┘
```

S5 — IS VOLTAGE VALUE OF VOLTAGE OUTPUT FROM ERROR AMPLIFIER LARGER THAN UPPER LIMIT STICKING DETERMINATION VALUE?

YES →

NO ↓

S7 — IS VOLTAGE VALUE OF VOLTAGE OUTPUT FROM ERROR AMPLIFIER SMALLER THAN LOWER LIMIT STICKING DETERMINATION VALUE?

YES →

NO ↓

S6 — PERFORM CONTROL SO THAT ELECTRIC CURRENT VALUE OF ELECTRIC CURRENT SIGNAL BECOMES VALUE OUTSIDE AND SMALLER THAN NORMAL RANGE

S9 — PERFORM CONTROL SO THAT ELECTRIC CURRENT SIGNAL WILL HAVE TARGET ELECTRIC CURRENT VALUE

S8 — PERFORM CONTROL SO THAT ELECTRIC CURRENT VALUE OF ELECTRIC CURRENT SIGNAL BECOMES VALUE OUTSIDE AND LARGER THAN NORMAL RANGE

END

FIG.3

FIG.4

EP 4 718 084 A1

# FIG.5

# FIG.6

EP 4 718 084 A1

Europäisches
Patentamt

European
Patent Office

Office européen
des brevets

# EUROPEAN SEARCH REPORT

**Application Number**

EP 25 20 2987

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 201 674 B1 (WARITA HIROHISA [JP] ET AL) 13 March 2001 (2001-03-13) * column 1, line 6 - column 9, line 53; figures 1,3 * | 1-10 | INV. G01R19/165 G05F1/46 G05F1/56 G05F1/565 |
| X | CN 104 536 507 A (VERISILICON MICROELECTRONICS SHANGHAI CO LTD ET AL.) 22 April 2015 (2015-04-22) * paragraph [0001] - paragraph [0073]; figure 4 * | 1,2,7-10 | G05F1/569 G05F1/573 G05F1/59 G05F1/613 |
| A | JP 2009 048328 A (YOKOGAWA ELECTRIC CORP) 5 March 2009 (2009-03-05) * Figure 4 and the corresponding text; figure 4 * | 1,3-6 | G06F1/30 H03F3/45 G08C19/02 H04B3/00 G05F1/618 |
| A | US 2023/308017 A1 (IWANO YOUICHI [JP]) 28 September 2023 (2023-09-28) * Figure 2 and the corresponding text; figure 2 * | 1,3-6 | |

**TECHNICAL FIELDS SEARCHED (IPC)**

G01R
G05F
H03F
G06F
G08C
H04B

The present search report has been drawn up for all claims

| Place of search | Date of completion of the search | Examiner |
|---|---|---|
| The Hague | 8 January 2026 | Cuk, Vladimir |

EPO FORM 1503 03.82 (P04C01)

## ANNEX TO THE EUROPEAN SEARCH REPORT
## ON EUROPEAN PATENT APPLICATION NO.

EP 25 20 2987

This annex lists the patent family members relating to the patent documents cited in the above-mentioned European search report.
The members are as contained in the European Patent Office EDP file on
The European Patent Office is in no way liable for these particulars which are merely given for the purpose of information.

08-01-2026

| Patent document cited in search report | | Publication date | Patent family member(s) | | Publication date |
|---|---|---|---|---|---|
| US 6201674 | B1 | 13-03-2001 | DE | 69937778 T2 | 04-12-2008 |
| | | | EP | 0994401 A2 | 19-04-2000 |
| | | | JP | 3065605 B2 | 17-07-2000 |
| | | | JP | 2000187515 A | 04-07-2000 |
| | | | KR | 20000028983 A | 25-05-2000 |
| | | | US | 6201674 B1 | 13-03-2001 |
| CN 104536507 | A | 22-04-2015 | NONE | | |
| JP 2009048328 | A | 05-03-2009 | JP | 5035612 B2 | 26-09-2012 |
| | | | JP | 2009048328 A | 05-03-2009 |
| US 2023308017 | A1 | 28-09-2023 | CN | 116805442 A | 26-09-2023 |
| | | | JP | 7468563 B2 | 16-04-2024 |
| | | | JP | 2023142058 A | 05-10-2023 |
| | | | US | 2023308017 A1 | 28-09-2023 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2024166456 A
- JP 2012099088 A